Europäisches Patentamt

European Patent Office

Office européen des brevets

(11) Publication number: **0 552 781 A2**

## EUROPEAN PATENT APPLICATION

(21) Application number: **93100923.7**

(22) Date of filing: **21.01.93**

(51) Int. Cl.5: **H04L 1/00**

(30) Priority: **21.01.92 JP 8726/92**

(43) Date of publication of application:
**28.07.93 Bulletin 93/30**

(84) Designated Contracting States:
**DE FR GB IT NL**

(71) Applicant: **NEC CORPORATION**
**7-1, Shiba 5-chome Minato-ku**
**Tokyo 108-01(JP)**

(72) Inventor: **Kawabata, Hisashi, c/o NEC**
**Corporation**
**7-1, Shiba 5-chome**
**Minato-ku, Tokyo(JP)**

(74) Representative: **Betten & Resch**
**Reichenbachstrasse 19**
**W-8000 München 5 (DE)**

(54) Voice signal communication with burst error reduction.

(57) In order to reduce adverse effects introduced by burst errors to a reproduction signal representative of a voice signal, a voice signal encoding device (11) comprises a cyclic encoder (35), between a digitizer (17) for digitizing an input voice signal and a convolution encoder (19) for encoding an encoder input signal into an encoded signal, to preliminarily encode the digital signal into the encoder input signal. A voice signal decoding device (13) comprises a detector (37), between a maximum likelihood decoder (17), such as a Viterbi decoder, and a voice signal decoder (19) for decoding a decoder input signal into the reproduced signal, to detect the burst errors remaining in a maximum likelihood code sequence. An interpolator (39) interpolates correct codes in the maximum likelihood code sequence to produce the decoder input signal in accordance with the burst errors detected by the detector.

FIG. 2

## BACKGROUND OF THE INVENTION:

This invention relates to voice signal communication between a voice signal transmission side and a voice signal reception side.

A voice signal communication network comprises a voice signal encoding device on a voice signal transmission side and a voice signal decoding device on a voice signal receiving side. A newly developed Viterbi decoder is described in an eight-page paper contributed by Yutaka Yasuda and three others under the title of "Development of Variable-rate Viterbi Decoder and its Performance Characteristics" to the Sixth International Conference on Digital Satellite Communications held 19 to 23 September 1983 in Phoenix, Arizona, the United States of America. A convolution encoder is also described in the Yasuda et al paper.

In the manner which will later be described more in detail, the voice signal encoding device of a conventional voice signal communication network comprises a digitizer for digitizing a voice signal into a digital signal. Supplied with the digitized signal as an encoder input signal, a convolution encoder encodes the encoder input signal into a convolution code sequence for transmission towards the voice signal decoding device as an encoded signal representative of the voice signal.

The voice signal decoding device comprises a maximum likelihood decoder, such as the Viterbi decoder mentioned above, for preliminarily decoding the encoded signal into a maximum likelihood code sequence. Supplied with the maximum likelihood code sequence as a decoder input signal, a voice signal decoder eventually decodes the decoder input signal into a reproduction signal representative of the last-mentioned voice signal.

It is known that the encoded signal is susceptible to burst errors during transmission from the voice signal encoding device to the voice signal decoding device. Such a burst error unavoidably remains in the maximum likelihood code sequence. Upon appearance of the burst errors, the reproduction signal is disturbed by noise.

## SUMMARY OF THE INVENTION:

It is consequently a principal object of the present invention to provide a voice signal communication method wherein a voice signal is encoded on a transmission side into an encoded signal and the encoded signal is decoded on a reception side into a reproduction signal representative of the voice signal and wherein a reduction is possible of adverse effects which are inevitably caused to the reproduction signal by burst errors introduced into the encoded signal transmitted from the transmission side to the reception side.

It is a subordinate object of this invention to provide a voice signal encoding device for use in carrying out the voice signal communication method of the type described.

It is another subordinate object of this invention to provide a voice signal decoding device for use in carrying out the voice signal communication method of the type described.

On setting forth the gist of this invention, it is possible to understand that a method for encoding a voice signal into an encoded signal on a transmission side and decoding the encoded signal into a reproduction signal representative of the voice signal on a reception side includes on the transmission side the steps of digitizing the voice signal into a digital signal and eventually encoding an encoder input signal into a convolution code sequence for use as the encoded signal and on the reception side the steps of preliminarily decoding the encoded signal into a maximum likelihood code sequence and eventually decoding a decoder input signal into the reproduction signal, wherein it should be noted that the maximum likelihood code sequence is susceptible to burst errors.

In accordance with this invention, the above-understood method comprises:

on the transmission side the steps of preliminarily encoding the digital signal into a cyclic code sequence and subjecting the cyclic code sequence to the eventually encoding step as the encoder input signal; and

on the reception side the steps of detecting the burst errors in the maximum likelihood code sequence to produce an error bit information signal, interpolating correct codes in the maximum likelihood code sequence in place of the burst errors in compliance with the error bit information signal to produce an error corrected code sequence, and subjecting the error corrected code sequence to the eventually decoding step as the decoder input signal.

On setting forth the gist of an aspect of this invention, it is possible to understand that a voice signal encoding device includes a digitizer for digitizing a voice signal into a digital signal, a convolution encoder for encoding an encoder input signal into a convolution code sequence representative of the voice signal, and supply means for supplying the digital signal to the convolution encoder as the encoder input signal.

In accordance with this aspect of the invention, the supply means of the above-understood voice signal encoding device comprises a cyclic encoder for encoding the digital signal into a cyclic code sequence for use as the encoder input signal.

On describing the gist of a different aspect of this invention, it is possible to understand that a voice signal decoding device is for decoding an encoded signal representative of a voice signal and susceptible to burst errors into a reproduction signal representative of the voice signal and includes a maximum likelihood decoder for decoding the encoded signal into a maximum likelihood code sequence, a voice signal decoder for decoding a decoder input signal into the reproduction signal, and supply means for supplying the maximum likelihood code sequence to the voice signal decoder as the decoder input signal.

In accordance with the different aspect of this invention, the supply means of the above-understood voice signal decoding device comprises a burst error detector for detecting the burst errors in the maximum likelihood code sequence to produce an error bit information signal representative of the burst errors and an interpolator for interpolating correct codes in the maximum likelihood code sequence in place of the burst errors to produce an error corrected code sequence for use as the decoder input signal.

BRIEF DESCRIPTION OF THE DRAWING:

Fig. 1 is a block diagram of a conventional voice signal encoding and decoding device; and
Fig. 2 is a block diagram of a voice signal encoding and decoding device according to an embodiment of the instant invention.

DESCRIPTION OF THE PREFERRED EMBODIMENT:

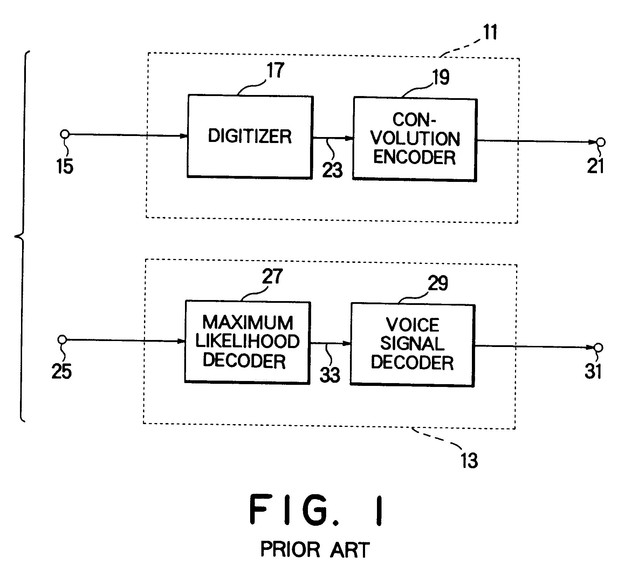

Referring to Fig. 1, a conventional voice signal encoding and decoding device will first be described in order to facilitate an understanding of the present invention. The voice signal encoding and decoding device is for use in cooperation with like other voice signal encoding and decoding devices (not shown) in a voice signal communication network with the voice signal encoding and decoding device being illustrated used as a communicating device and with at least one of the other voice signal encoding and decoding devices used as a counterpart device.

In Fig. 1, the voice signal encoding and decoding device comprises a voice signal encoding device 11 and a voice signal decoding device 13. Through an encoder input terminal 15, an input voice signal is supplied to a voice signal encoder that serves as a digitizer 17 for digitizing the voice signal into a digital signal. Supplied with the digital signal as an encoder input signal, a convolution encoder 19 encodes the encoder input signal into a convolution code sequence, which is delivered to an encoder output terminal 21 as a first encoded signal representative of the input voice signal. From the output terminal 21, the encoded signal is delivered through a modulator and a transmitter (both not shown) towards the counterpart device as a first transmission signal. It should be known that a first connection 23 between the digitizer 17 and the convolution encoder 19 serves as an encoder supply arrangement for supplying the digital signal from the digitizer 17 to the convolution encoder 19 as the encoder input signal.

Comprising similar parts, a voice signal encoding device of the counterpart device supplies towards the voice signal decoding device 13 being illustrated with a second transmission signal representative of a transmission voice signal. Through a receiver and a demodulator (both not shown), the second transmission signal is delivered to a decoder input terminal 25 as a second encoded signal.

The voice signal decoding device comprises a maximum likelihood decoder 27 for preliminarily decoding the second encoded signal into a maximum likelihood code sequence. Supplied with the maximum likelihood code sequence as a decoder input signal, a voice signal decoder 29 eventually decodes the decoder input signal into a baseband reproduction signal representative of the transmission voice signal. The reproduction signal is delivered to a decoder output terminal 31. Between the maximum likelihood decoder 27 and the voice signal decoder 29, a second connection 33 serves as a decoder supply arrangement for supplying the maximum likelihood code sequence from the maximum likelihood decoder 27 to the voice signal decoder 29 as the decoder input signal.

Typically, a Viterbi decoder is used as the maximum likelihood encoder. The Viterbi decoder may be that described in the Yasuda et al paper cited heretobefore. On the other hand, it is known that the first and the second transmission signals are susceptible to burst errors and random errors. When supplied to the Viterbi decoder, the encoded signal is susceptible to the burst errors and the random errors. The Viterbi decoder is capable of correcting the random errors and produce the maximum likelihood code sequence with no random error. The burst errors, however, unavoidably remain in the maximum likelihood code sequence. Remaining in the maximum likelihood code sequence, the burst errors give rise to noise in the reproduction signal.

It will be assumed among numerical examples given in the Yasuda et al paper that the encoded signal is transmitted at an information data rate or speed R of 4.8 kbauds with a coding rate of 7/8. The Viterbi decoder will be assumed to carry out an eight-level soft decision which is mainly discussed in the Yasuda et al paper. It is possible to judge from the viewpoint of aural sense that no problem results from occurrence of burst errors once in ten minutes with an average burst error length L of about ten bits. A case will therefore be taken into consideration wherein the burst errors occur with an average burst error length of ten bits and with an average time interval T(av) of 10 x 60 seconds and wherein the random errors are completely corrected by the Viterbi decoder. A bit error rate (BER) of the maximum likelihood code sequence is given by L/(RT(av)) and is equal to 3.5 x $10^{-6}$. This corresponds to an Eb/No (Eb representing energy per information bit and No representing a noise power density) of 5.6 dB.

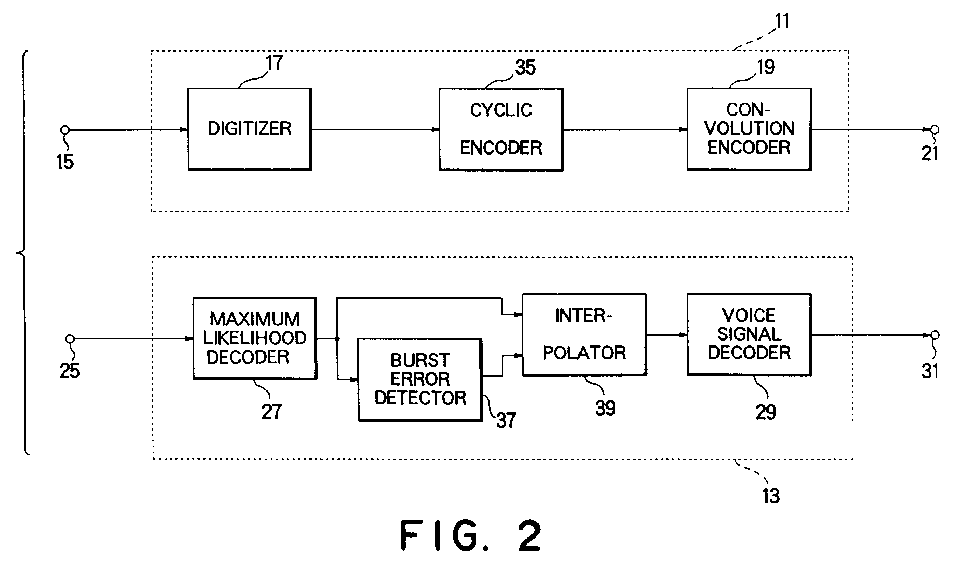

Referring now to Fig. 2, the description will proceed to a voice signal encoding and decoding device according to a preferred embodiment of this invention. Similar parts are designated by like reference numerals and are similarly operable with likewise named signals.

In Fig. 2, the voice signal encoding device 11 comprises a cyclic code encoder 35 for preliminarily encoding the digital signal into a cyclic code sequence. Supplied with the cyclic code sequence as the encoder input signal, the voice signal encoder 11 eventually encodes the cyclic code sequence into the first encoded signal. It will now be appreciated that the encoder supply means (23) of Fig. 1 comprises in Fig. 2 the cyclic encoder 35 for producing the cyclic code sequence for use as the encoder input signal.

The voice signal decoding device 13 comprises a burst error detector 37 for detecting the burst errors in the maximum likelihood code sequence to produce an error bit information signal indicative of the burst errors in the maximum likelihood code sequence. Supplied with the maximum likelihood code sequence and the error bit information signal, an interpolator 39 interpolates correct codes in the maximum likelihood code sequence in place of the burst errors indicated by the error bit information signal to produce an error corrected code sequence. Supplied with the error corrected code sequence instead of the maximum likelihood code sequence which may include the burst errors, the voice signal decoder 29 eventually decodes the decoder input signal into the reproduction signal. It is appreciated that the decoder supply means (33) of Fig. 1 comprises in Fig. 2 the burst error detector 37 and the interpolator 39 for interpolating the correct codes in accordance with the error bit information signal and that the interpolator 39 produces the error corrected code sequence for use as the decoder input signal.

By way of example, it will be assumed that the information bit rate of 4.8 kbauds, the coding rate of 3/4, and the eight-level soft decisions are used among the examples cited in the Yasuda et al paper and that a sixteen-bit cyclic code sequence is used. Under the circumstances, it is known that the burst errors are always detected when the burst errors are not longer than sixteen bits. Burst errors may or may not be detected when the burst errors are longer than sixteen bits. A probability P (mis) that the burst errors are not detected, is equal to $3/2^{16}$. According to the Yasuda et al paper, the average burst error length L is fourteen bits long in order to attain a bit error rate of $10^{-3}$. The average time interval T(av) is therefore 2.9 seconds long. A time interval T(mis) during which the burst errors can not be detected is equal to T(av)/P(mis) and equal to 3.4 days. It is now understood that the voice signal encoding and decoding device is capable of reducing in accordance with this invention the adverse effects which would otherwise be introduced into the reproduction signal.

Attention will now be directed to the Eb/No, which is equal to 3.8 dB in the above-described numerical example according to the Yasuda et al paper when the bit error rate is equal to $10^{-3}$. A frame length of 484 bits will be assumed for the digital signal. According to this invention, the digital signal is preliminarily encoded into the cyclic code sequence before eventually encoded into the encoded signal. When the sixteen bits are used, the cyclic code sequence has a frame length of 500 bits. The Eb/No increases by 10log500/484 = 0.14 dB. Namely, the Eb/No is not greater than 4.0 dB. It is consequently appreciated that the Eb/No is kept low in accordance with this invention.

Thus the invention can be summarized as follows:

In order to reduce adverse effects introduced by burst errors to a reproduction signal representative of a voice signal, a voice signal encoding device (11) comprises a cyclic encoder (35), between a digitizer (17) for digitizing an input voice signal and a convolution encoder (19) for encoding an encoder input signal into an encoded signal, to preliminarily encode the digital signal into the encoder input signal. A voice signal decoding device (13) comprises a detector (37), between a maximum likelihood decoder (17), such as a Viterbi decoder, and a voice signal decoder (19) for decoding a decoder input signal into the reproduced signal, to detect the burst errors remaining in a maximum likelihood code sequence. An interpolator (39) interpolates correct codes in the maximum likelihood code sequence to produce the decoder input signal in accordance with the burst errors detected by the detector.

## Claims

1. A method of encoding a voice signal into an encoded signal on a transmitting side and decoding said encoded signal into a reproduction signal representative of said voice signal on a reception side, said method including on said transmission side the steps of digitizing said voice signal into a digital signal and eventually encoding an encoder input signal into a convolution code sequence for use as said encoded signal and on said reception side the steps of preliminarily decoding said encoded signal into a maximum likelihood code sequence and eventually decoding a decoder input signal into said reproduction signal, said maximum likelihood code sequence being susceptible to burst errors, wherein said method comprises:

on said transmitting side the steps of preliminarily encoding said digital signal into a cyclic code sequence and subjecting said cyclic code sequence into said eventually encoding step as said encoder input signal; and

on said reception side the steps of detecting said burst errors in said maximum likelihood code sequence to produce an error bit information signal, interpolating correct codes in the maximum likelihood code sequence in place of said burst errors in compliance with said error bit information signal to produce an error corrected code sequence, and subjecting said error corrected code sequence to said eventually decoding step as said decoder input signal.

2. A voice signal encoding device including a digitizer for digitizing a voice signal into a digital signal, a convolution encoder for encoding an encoder input signal into a convolution code sequence representative of said voice signal, and supply means for supplying said digital signal to said convolution encoder as said encoder input signal, wherein said supply means comprises a cyclic code encoder for encoding said digital signal into a cyclic code sequence for use as said encoder input signal.

3. A voice signal decoding device for decoding an encoded signal representative of a voice signal and susceptible to burst errors into a reproduction signal representative of said voice signal, said voice signal decoding device including a maximum likelihood decoder for decoding said encoded signal into a maximum likelihood code sequence, a voice signal decoder for decoding a decoder input signal into said reproduced signal, and supply means for supplying said maximum likelihood code sequence to said voice signal decoder as said decoder input signal, wherein said supply means comprises:

a burst error detector for detecting said burst errors in said maximum likelihood code sequence to produce an error bit information signal representative of said burst errors; and

an interpolator for interpolating correct codes in said maximum likelihood code sequence in place of said burst errors to produce an error corrected code sequence for use as said decoder input signal.

FIG. 1

PRIOR ART

EP 0 552 781 A2

FIG. 2

EP 0 552 781 A2